(19) **Europäisches Patentamt / European Patent Office / Office européen des brevets**

(11) **EP 2 715 379 B1**

(12) **FASCICULE DE BREVET EUROPEEN**

(45) Date de publication et mention
de la délivrance du brevet:
**05.09.2018 Bulletin 2018/36**

(21) Numéro de dépôt: **12725039.7**

(22) Date de dépôt: **01.06.2012**

(51) Int Cl.:
**G01R 31/02** (2006.01)     **B60L 3/00** (2006.01)
**G01R 27/18** (2006.01)

(86) Numéro de dépôt international:
**PCT/EP2012/060395**

(87) Numéro de publication internationale:
**WO 2012/164073 (06.12.2012 Gazette 2012/49)**

(54) **DETECTION D'UN DEFAUT D'ISOLEMENT**

NACHWEIS EINES ISOLATIONSDEFEKTS

DETECTION OF AN INSULATION DEFECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.06.2011 FR 1154849**
**01.06.2011 FR 1154850**

(43) Date de publication de la demande:
**09.04.2014 Bulletin 2014/15**

(73) Titulaire: **COMMISSARIAT À L'ÉNERGIE ATOMIQUE ET AUX ÉNERGIES ALTERNATIVES**
**75015 Paris (FR)**

(72) Inventeurs:
- **CHATROUX, Daniel**
  **F-38470 Teche (FR)**
- **CARCOUET, Sébastien**
  **F-38450 Vif (FR)**
- **DAUCHY, Julien**
  **F-38160 Chatte (FR)**

(74) Mandataire: **Colombo, Michel**
**Brevinnov**
**310 avenue Berthelot**
**69008 Lyon (FR)**

(56) Documents cités:
| | |
|---|---|
| **EP-A1- 0 654 673** | **EP-A1- 1 289 094** |
| **EP-A1- 1 857 825** | **EP-A1- 2 333 568** |
| **WO-A1-2008/088448** | **WO-A1-2009/043772** |
| **JP-A- 8 163 704** | **US-A- 5 818 236** |
| **US-A1- 2003 234 653** | **US-A1- 2004 212 371** |
| **US-A1- 2005 146 335** | **US-A1- 2007 285 057** |

- **LU BI ET AL: "A High-voltage Safety Protection Method for Electric Vehicle Based on FPGA", VEHICULAR ELECTRONICS AND SAFETY, 2006. ICVES 2006. IEEE INTERNATIONAL CONFERENCE ON, IEEE, PI, 1 décembre 2006 (2006-12-01), pages 26-31, XP031177221, ISBN: 978-1-4244-0758-3**

EP 2 715 379 B1

Printed by Jouve, 75001 PARIS (FR)

## Description

L'invention concerne l'isolement d'un réseau ou d'une alimentation électrique à tension continue par rapport à la terre.

Les systèmes électriques de forte puissance à tension continue connaissent un développement important. En effet, de nombreux systèmes de transport incluent une alimentation de tension continue.

Les véhicules hybrides combustion/électrique ou électriques incluent notamment des batteries de forte puissance. Pour obtenir le niveau de tension adéquat, on place en série plusieurs accumulateurs électrochimiques. Pour obtenir de fortes puissances et capacités, on place plusieurs groupes d'accumulateurs en série. Le nombre d'étages (nombre de groupes d'accumulateurs) et le nombre d'accumulateurs en parallèle dans chaque étage varient en fonction de la tension, du courant et de la capacité souhaités pour la batterie. L'association de plusieurs accumulateurs est appelée une batterie d'accumulateurs. Les accumulateurs électrochimiques utilisés pour de tels véhicules sont généralement du type lithium ion pour leur capacité à stocker une énergie importante avec un poids et un volume contenus. Les technologies de batterie de type Lithium ion phosphate de fer LiFeP04 font l'objet d'importants développements du fait d'un niveau de sécurité intrinsèque élevé, au détriment d'une densité de stockage d'énergie un peu en retrait.

De telles batteries sont utilisées pour entraîner un moteur électrique à courant alternatif par l'intermédiaire d'un onduleur. Les niveaux de tension nécessaires pour de tels moteurs atteignent plusieurs centaines de Volts, typiquement de l'ordre de 400 Volts. De telles batteries comportent également une forte capacité afin de favoriser l'autonomie du véhicule en mode électrique. Plusieurs raisons techniques spécifiques à l'application automobile amènent à l'utilisation d'un isolement entre la masse mécanique du véhicule (formée par le châssis et la carrosserie métalliques du véhicule, et donc accessibles à l'utilisateur) et les potentiels de la batterie. La raison principale est qu'il n'est pas envisageable lors d'un premier défaut d'isolement en roulage de déconnecter instantanément la batterie de traction. Par exemple, dans le cas où l'un des pôles de la batterie est relié à la mécanique et que le défaut d'isolement apparait sur l'autre pôle. Ceci se traduit par un court-circuit et la fusion immédiate du fusible de protection. Cela aurait pour effet de rendre le véhicule dangereux. Du fait de la disparition de la puissance de traction ou du freinage récupératif, ceci oblige donc à devoir isoler la batterie et surveiller cet isolement pour des raisons de sécurité des personnes par un contrôleur d'isolement. En effet, si lors d'un premier défaut il n'y a aucun risque pour l'utilisateur, il convient de l'alerter de ce premier défaut avant l'apparition d'un second défaut ayant pour effet de déconnecter la batterie de traction car provoquant un court-circuit entre les bornes positive et négative de la batterie. De plus, lors de ce second défaut, la tension de la batterie serait directement reliée à la masse mécanique du véhicule et l'utilisateur serait donc potentiellement en contact avec celle-ci. Du fait du risque potentiel d'une telle source d'énergie pour les utilisateurs, l'isolement et le contrôle de l'isolement entre la batterie et la masse mécanique doivent être particulièrement soignés. Toute partie conductrice du véhicule doit être isolée par rapport aux masses. Cet isolement est réalisé par l'utilisation de matériaux isolants. L'isolement peut se détériorer avec le temps (à cause des vibrations, des chocs mécaniques, de la poussière, etc.), et donc mettre la masse mécanique sous un potentiel dangereux.

Par ailleurs, il peut être envisagé d'utiliser un chargeur non isolé galvaniquement du réseau électrique. La masse mécanique du véhicule étant normativement reliée à la terre lors des recharges et le régime de neutre utilisé classiquement (régime TT) en résidentiel connectant le neutre à la terre, cela revient à connecter pendant les recharges la masse mécanique du véhicule à un des potentiels de la batterie. Pendant ces recharges, la tension complète de la batterie est donc appliquée aux bornes de l'isolement contrairement au cas nominal où seulement la moitié de cette tension est appliquée et surtout contrôlée. Cet isolement pourrait ne pas être capable de tenir la tension complète créant un second défaut instantanément ayant pour conséquence un court-circuit.

Un véhicule électrique selon l'état de la technique présente typiquement une batterie destinée à l'alimentation d'un moteur électrique triphasé. La batterie comprend des accumulateurs électrochimiques. Un dispositif de protection muni de fusibles est connecté aux bornes de la batterie. Un dispositif de contrôle d'isolement est également connecté aux bornes de la batterie et raccordé à la masse mécanique du véhicule. Le dispositif de contrôle d'isolement est connecté à un calculateur pour lui signaler les défauts d'isolement détectés. Ce calculateur est alimenté par une batterie de réseau de bord. Les bornes de la batterie appliquent des tensions +Vbat et -Vbat sur les entrées continues d'un onduleur par l'intermédiaire d'un système de coupure. Le système de coupure comprend des contacteurs de puissance commandés par le calculateur. Le moteur électrique est connecté à la sortie alternative de l'onduleur. Différents types de contrôle d'isolement sont connus de l'état de la technique.

Le document FR2671190 décrit notamment un dispositif de contrôle d'isolement d'un réseau électrique à tension continue. Ce document décrit un pont résistif injectant une composante alternative (environ 30 V) à basse fréquence (entre 4 et 10Hz). Un circuit de détection mesure un courant traversant une impédance d'isolement et une résistance de mesure jusqu'à la masse. La conception d'un tel circuit implique un compromis dans le dimensionnement des résistances du pont résistif.

Le pont résistif induit une consommation électrique restant relativement importante afin de garder une précision de mesure convenable. Une telle consommation de courant peut s'avérer incompatible avec une application dans les systèmes embarqués, par exemple du fait de la baisse d'autonomie d'un véhicule électrique. De plus, un tel dispositif est relativement coûteux notamment du fait de l'utilisation d'un générateur basse fréquence dimensionné pour une tension continue élevée. En outre, le circuit de détection ne permet que la détection d'un défaut d'isolement entre une des bornes et la masse, mais pas la détection d'un défaut d'isolement entre l'autre borne et la masse. Par ailleurs, un tel dispositif de contrôle est sensible à des faux positifs qui se traduisent par des détections intempestives puisqu'il détecte un défaut d'isolement lorsque des condensateurs de mode commun présents dans l'onduleur sont parcourus par des courants alternatifs.

Dans une autre solution usuellement mise en oeuvre dans un véhicule électrique 1, le dispositif de contrôle d'isolement comprend un diviseur de tension résistif. Un optocoupleur bidirectionnel est connecté entre le point milieu du diviseur de tension et la masse mécanique. Les résistances du diviseur de tension de part et d'autre du point milieu sont identiques. Ainsi, en l'absence de défaut d'isolement, la tension aux bornes de l'optocoupleur est nulle et aucun défaut d'isolement n'est signalé. Lors de l'apparition d'un défaut d'isolement entre une des bornes de la batterie et la masse mécanique, le potentiel du point milieu du diviseur de tension est décalé. Une tension apparaît alors aux bornes de l'optocoupleur, ce qui génère un signal de défaut d'isolement.

La réglementation imposant un seuil de courant de fuite à détecter relativement bas, les résistances présentes dans le diviseur de tension doivent présenter une valeur relativement réduite, de l'ordre de 50 K$\Omega$. Ces résistances induisent alors une consommation électrique continue relativement importante au détriment de l'autonomie fournie par la batterie.

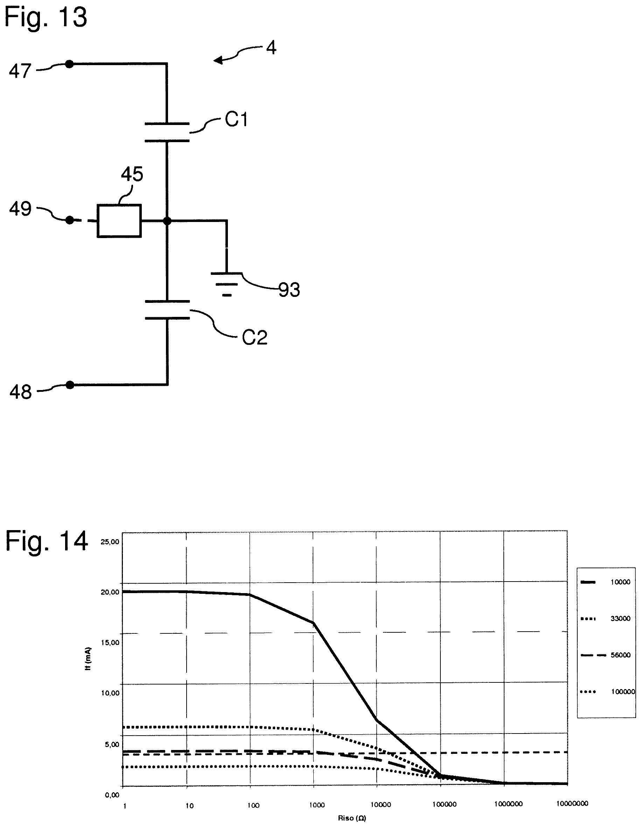

Le diagramme de la figure 14 illustre le courant de fuite pour une tension de batterie minimum (en l'occurrence de 192 V) en fonction de la résistance d'isolement, pour différentes valeurs de résistances entre les bornes et le point milieu. On constate qu'une valeur des résistances de 10 k$\Omega$ permet par exemple de détecter des résistances de défaut d'isolement inférieures à 50 K$\Omega$, tandis qu'une valeur des résistances de 56 K$\Omega$ permet de détecter des résistances de défaut d'isolement seulement inférieures à 1 k$\Omega$.

En outre, du fait du vieillissement, certains matériaux d'isolement peuvent s'avérer appropriés pour supporter la tension entre la masse mécanique et une borne de la batterie en fonctionnement normal, mais peuvent claquer lorsqu'ils sont soumis à la tension totale entre les bornes de la batterie du fait d'un défaut d'isolement. Un tel dispositif de contrôle ne permet pas de tester et de détecter un tel défaut d'isolement potentiel, ce qui peut conduire à des défauts d'isolement en chaîne. Un premier défaut d'isolement sur une polarité applique la tension totale entre l'autre polarité et la masse. Si l'isolement de cette autre polarité n'était pas apte à le supporter, le second défaut d'isolement apparait. Ceci crée un court-circuit avec fusion des fusibles. Ceci correspond à une perte de traction puis une immobilisation soudaine du véhicule qui est dangereuse.

De plus, un tel dispositif de contrôle d'isolement permet uniquement de détecter le défaut d'isolement, mais pas de déterminer son ampleur. Etat de la technique pertinent peut être trouvé dans les documents EP1857825, WO2008/088448 et US2004212371. L'invention vise à résoudre un ou plusieurs de ces inconvénients. L'invention a pour objet un dispositif d'alimentation électrique tel que défini par la revendication 1. L'invention a également pour objet un système de motorisation tel que défini par la revendication 13 et un véhicule automobile comprenant un système de motorisation tel que défini par la revendication 15.

L'invention porte ainsi sur un dispositif d'alimentation électrique, comprenant :

-    une source de tension continue susceptible d'induire une électrocution ;
-    un dispositif de détection d'un défaut d'isolement de la source de tension continue, comprenant :

    -    des première et deuxième bornes d'entrée connectées aux bornes de la source de tension;
    -    un premier circuit connecté entre la première borne d'entrée et un point intermédiaire ;
    -    un deuxième circuit connecté entre la deuxième borne d'entrée et ledit point intermédiaire ;
    -    un circuit de détection de courant de défaut d'isolement connecté entre une masse électrique et ledit point intermédiaire.

    Lesdits premier et deuxième circuits sont des limiteurs de courant configurés pour ouvrir et fermer sélectivement la connexion entre leur borne d'entrée respective et le point intermédiaire, chacun desdits circuits limiteurs de courant étant dimensionné pour être traversé par un courant inférieur à un seuil de sécurité normé lorsque le premier ou le deuxième circuit limiteur de courant est fermé et que l'une des bornes de la source de tension continue est court-circuitée à la masse électrique.

    Un circuit de commande est configuré pour simultanément maintenir un desdits circuits limiteurs de courant ouvert et l'autre desdits circuits limiteurs de courant fermé.

Selon une variante, chacun desdits circuits limiteurs de courant comprend un optocoupleur commandé par le circuit de commande de façon à ouvrir et fermer sélectivement la connexion dans son circuit limiteur de courant respectif.

Selon encore une variante, le dispositif comprend un premier condensateur connecté en parallèle du premier circuit limiteur de courant entre la première borne d'entrée et la masse électrique, un deuxième condensateur connecté en parallèle du deuxième circuit limiteur de courant entre la deuxième borne d'entrée et la masse électrique, le circuit de commande étant configuré pour détecter la décharge d'un desdits condensateurs lors de la fermeture de la connexion d'un desdits circuits limiteurs de courant.

Selon une autre variante, le circuit de commande ferme chacun des circuits limiteurs de courant de façon répétée avec un intervalle temporel compris entre 10 et 30 secondes.

Selon encore une autre variante, le circuit de commande maintient lesdits circuits limiteurs de courant fermés avec un rapport cyclique inférieur à 2 %.

Selon une variante, le circuit de détection de courant comprend un microcontrôleur comportant une borne d'entrée recevant le courant de défaut d'isolement provenant du point intermédiaire, ladite borne d'entrée étant connectée à une alimentation par l'intermédiaire d'une première résistance, ladite borne d'entrée étant par ailleurs connectée à la masse électrique par l'intermédiaire d'une deuxième résistance, ladite alimentation étant à un niveau de tension au moins dix fois inférieur au niveau de tension de la source de tension continue, ledit microcontrôleur étant configuré pour déterminer l'amplitude d'un défaut d'isolement en fonction de la tension appliquée sur sa borne d'entrée.

Selon encore une variante, chaque circuit limiteur de courant comprend :

- un premier transistor comportant une électrode d'entrée connectée à une borne d'entrée respective du dispositif de détection, une électrode de sortie et une électrode de commande ;
- une première résistance connectée entre l'électrode d'entrée et l'électrode de commande ;
- une deuxième résistance connectée entre l'électrode de sortie et le point intermédiaire ;
- un organe de limitation du niveau de tension sur l'électrode de commande.

Selon une autre variante, ledit premier transistor est un transistor MOSFET.

Selon encore une variante, l'organe de limitation du niveau de tension est une diode zener connectée entre l'électrode de commande du premier transistor et le point intermédiaire.

Selon encore une autre variante, l'organe de limitation du niveau de tension est un transistor bipolaire dont la base est connectée à l'électrode de sortie du premier transistor, dont l'émetteur est connecté au point intermédiaire et dont le collecteur est connecté à l'électrode de commande du premier transistor.

Selon encore une autre variante, chacun desdits circuits limiteurs de courant est dimensionné pour être traversé par un courant inférieur à 3.5mA lorsque le premier ou le deuxième circuit limiteur de courant est fermé et que l'une des bornes de la source de tension continue est court-circuitée à la masse électrique.

Selon une variante, chacun desdits circuits limiteurs de courant est dimensionné de façon à, lorsque le circuit de commande lui applique une commande de fermeture, rester fermé lorsqu'il est traversé par un courant induit par un court-circuit entre l'une des bornes de la source de tension continue et la masse électrique.

L'invention porte également sur un système de motorisation, comprenant:

- un dispositif d'alimentation électrique tel que décrit ci-dessus, dans lequel la source de tension continue est une batterie ;
- un onduleur présentant une interface continu et une interface alternatif, les bornes de la batterie étant connectées à l'interface continu;
- un moteur électrique connecté à l'interface alternatif de l'onduleur.

Selon une variante, la tension aux bornes de la batterie est supérieure à 100 V.

L'invention porte en outre sur un véhicule automobile comprenant un système de motorisation tel que décrit ci-dessus.

D'autres caractéristiques et avantages de l'invention ressortiront clairement de la description qui en est faite ci-après, à titre indicatif et nullement limitatif, en référence aux dessins annexés, dans lesquels :

- la figure 1 est une représentation schématique d'un exemple de véhicule à moteur électrique alimenté par batterie;
- la figure 2 est une représentation schématique d'un mode de réalisation d'un dispositif de détection de défaut d'isolement pour un dispositif d'alimentation électrique;
- les figures 3 et 4 illustrent les configurations du dispositif de détection de défaut d'isolement durant deux phases de contrôle ;
- la figure 5 est un schéma électrique d'une première variante de limiteur de courant;
- la figure 6 est un schéma électrique d'une deuxième variante de limiteur de courant;
- la figure 7 est un schéma électrique d'une troisième variante de limiteur de courant;
- la figure 8 est un schéma électrique d'une quatrième variante de limiteur de courant;
- la figure 9 est un schéma électrique d'un perfectionnement appliqué à la troisième variante ;
- la figure 10 est un schéma électrique d'une cinquième variante de limiteur de courant ;
- la figure 11 est une représentation schématique d'un circuit de détection de courant de fuite à seuil ;
- la figure 12 est une représentation schématique d'un circuit de quantification du courant de fuite ;
- la figure 13 est une représentation schématique d'un perfectionnement permettant de tester le dispositif de détection ;
- la figure 14 est un diagramme illustrant différents courants de fuite détectés en fonction du dimensionnement de résistances du dispositif de détection de défaut d'isolement ;

- les figures 15 et 16 sont des schémas électriques d'un circuit de détection de défaut d'isolement incluant des variantes de limiteurs de courant.

L'invention propose un dispositif d'alimentation électrique muni d'un dispositif de détection d'un défaut d'isolement d'une source de tension continue susceptible d'induire une électrocution. Ce dispositif comprend des première et deuxième bornes d'entrée destinées à être connectées aux bornes de la source de tension. Un premier circuit est connecté entre la première borne d'entrée et un point intermédiaire, un deuxième circuit étant connecté entre la deuxième borne d'entrée et ledit point intermédiaire. Un circuit de détection de courant de défaut d'isolement est connecté entre une masse électrique et le point intermédiaire.

Les premier et deuxième circuits sont des limiteurs de courant configurés pour ouvrir et fermer sélectivement la connexion entre leur borne d'entrée respective et le point intermédiaire. Un circuit de commande est configuré pour simultanément maintenir un desdits circuits limiteurs de courant ouvert et l'autre desdits circuits limiteurs de courant fermé.

L'invention permet ainsi de détecter l'apparition d'un défaut d'isolement sur les deux bornes de la source, avec une consommation de courant réduite et par des moyens simples. En outre, l'invention permet de détecter un défaut d'isolement en appliquant toute la différence de potentiel de la source aux bornes des isolants lors d'un test. On peut donc déterminer préventivement un risque de défaut d'isolement par claquage de diélectrique. L'invention permet en outre de se dispenser de l'injection d'une composante alternative basse fréquence aux bornes de la source de tension continue. L'invention permet par ailleurs d'améliorer la sensibilité de la détection, sans altérer la protection des utilisateurs.

Cette invention va en outre à l'encontre d'un préjugé technique de l'homme du métier réalisant des dispositifs de détection de défaut d'isolement, selon lequel l'utilisation de composants actifs ne permet pas d'assurer une fiabilité satisfaisante et donc une protection suffisante des utilisateurs.

La définition usuellement reconnue (par exemple fournie par le cahier technique 162 édité par la société Schneider Electric en septembre 1998) pour un limiteur de courant est un dispositif qui, lors d'un court-circuit, laisse passer un courant nettement inférieur en amplitude au courant présumé, en se basant sur le courant qu'il laisse passer en l'absence de court-circuit. On désignera par la suite par limiteur de courant un composant ou circuit présentant une impédance sensiblement constante lorsque la tension à ses bornes est inférieure à une tension de saturation, et une impédance proportionnelle à la tension à ses bornes lorsque cette tension est supérieure audit seuil de saturation. Cette propriété peut être mise à profit pour assurer une bonne sensibilité de mesure sous la tension de saturation, puis assurer une protection suffisante des utilisateurs au-dessus de la tension de saturation.

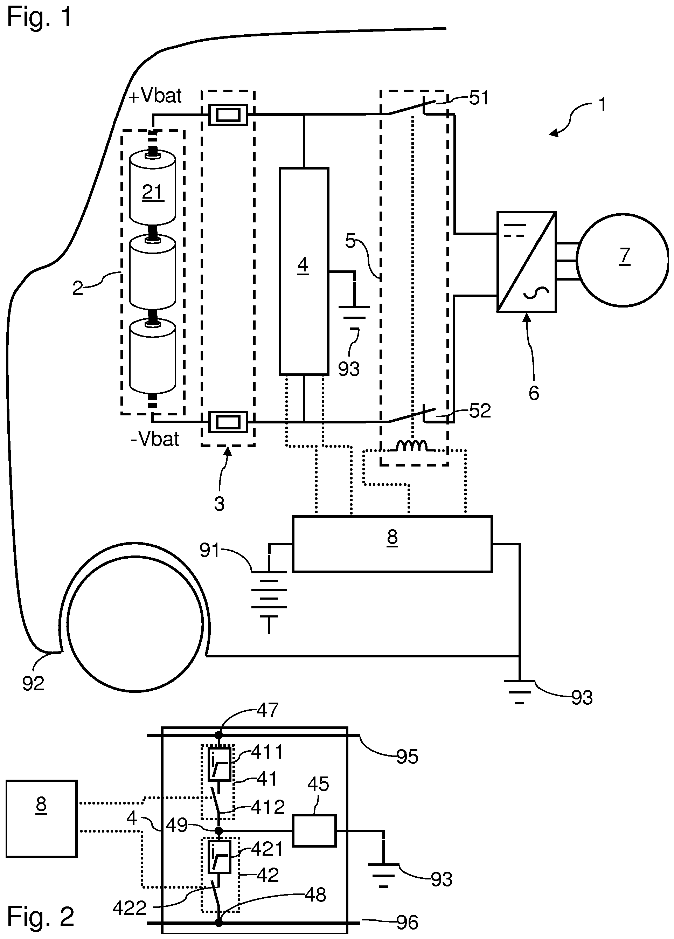

La figure 1 illustre un exemple de véhicule 1 mettant en oeuvre un mode de réalisation de l'invention. Le véhicule 1 est un véhicule électrique comprenant de façon connue en soi une batterie 2 incluant des accumulateurs électrochimiques 21 connectés en série. La batterie 2 comprend un grand nombre d'accumulateurs 21 connectés en série, typiquement entre 40 et 150 accumulateurs en fonction de la tension nécessaire et du type d'accumulateurs utilisé. La tension aux bornes de la batterie 2 chargée est typiquement de l'ordre de 400 V. La batterie 2 applique une tension +Vbat sur une première borne, et une tension -Vbat sur une deuxième borne. Les accumulateurs 21 sont connectés en série par l'intermédiaire de connexions électriques de puissance. Les bornes de la batterie 2 sont connectées à une interface continu d'un onduleur 6. Un moteur électrique 7 est connecté sur une interface alternatif de l'onduleur 6.

La connexion entre les bornes de la batterie 2 et l'interface continu de l'onduleur 6 est réalisée par l'intermédiaire d'un circuit de protection 3 et par l'intermédiaire d'un circuit d'accouplement de puissance 5. Le circuit de protection 3 peut comprendre de façon connue en soi des fusibles configurés pour ouvrir la connexion lors d'un court-circuit. Le circuit d'accouplement de puissance 5 comprend des interrupteurs 51 et 52 permettant de connecter/déconnecter sélectivement les bornes de la batterie 2 à l'interface continu de l'onduleur 6. L'ouverture/fermeture des interrupteurs 51 et 52 est commandée par un circuit de commande 8, typiquement un calculateur de supervision du fonctionnement de la batterie 2. Le circuit de commande 8 est typiquement alimenté par l'intermédiaire d'une batterie 91 d'alimentation du réseau de bord du véhicule 1, présentant un niveau de tension très inférieur à celui de la batterie 2. Le circuit de commande 8 est typiquement connecté à la masse mécanique 93, incluant le châssis et la carrosserie 92 métalliques du véhicule 1.

Un dispositif de détection d'un défaut d'isolement 4 est connecté aux bornes de la batterie 2 et à la masse mécanique 93. Un mode de réalisation d'un tel dispositif de détection 4 est détaillé schématiquement à la figure 2. Le dispositif de détection 4 comporte des bornes d'entrée 47 et 48 sur lesquelles sont appliquées respectivement les tensions +Vbat et -Vbat par l'intermédiaire des connexions de puissance 95 et 96. Le dispositif de détection 4 comporte un point intermédiaire 49. Un circuit de détection 45 d'un courant de défaut d'isolement est connecté entre le point intermédiaire 49 et la masse mécanique 93. Un circuit de limitation de courant 41 est connecté entre la borne d'entrée 47 et le point intermédiaire 49. Comme illustré, le circuit 41 présente une fonction de limitation de courant 411, dimensionnée pour limiter le courant traversant le circuit 41 à une valeur inférieure à un seuil de sécurité fixé par des normes pour les courants de défaut d'isolement, par exemple 3.5 milli-ampères. Le circuit 41 présente en outre une fonction d'interrupteur 412 permettant sélectivement d'ouvrir et de fermer la connexion entre la borne d'entrée 47 et le point intermédiaire 49. L'ouverture/fermeture de la fonction d'interrupteur 412 est commandée par le circuit de commande 8.

Un circuit de limitation de courant 42 est connecté entre la borne d'entrée 48 et le point intermédiaire 49. Le circuit 42 présente une fonction de limitation de courant 421, dimensionnée pour limiter le courant traversant le circuit 42 à une valeur inférieure à un seuil de sécurité fixé par des normes pour les courants de défaut d'isolement, par exemple 3.5 milliampères. Le circuit 42 présente en outre une fonction d'interrupteur 422 permettant sélectivement d'ouvrir et de fermer la connexion entre la borne d'entrée 48 et le point intermédiaire 49. L'ouverture/fermeture de la fonction d'interrupteur 422 est commandée par le circuit de commande 8.

Les fonctions de limitation de courant 411 et 421 seront avantageusement dimensionnées de sorte que pour une résistance de défaut d'isolement nulle, le courant les traversant lors de la fermeture de la fonction d'interrupteur 412 ou 422 soit inférieur à une valeur de sécurité Imax. Dans ce cas, la valeur Imax est définie par Imax=Vb/Zmax, avec Vb la tension nominale de la batterie et Zmax l'impédance de la fonction de limitation de courant lorsque la tension Vb est appliquée à ses bornes. Imax pourra être inférieur ou égal à 10mA, inférieur à 5mA, inférieur ou égal à 3,5mA ou inférieur ou égal à 2mA.

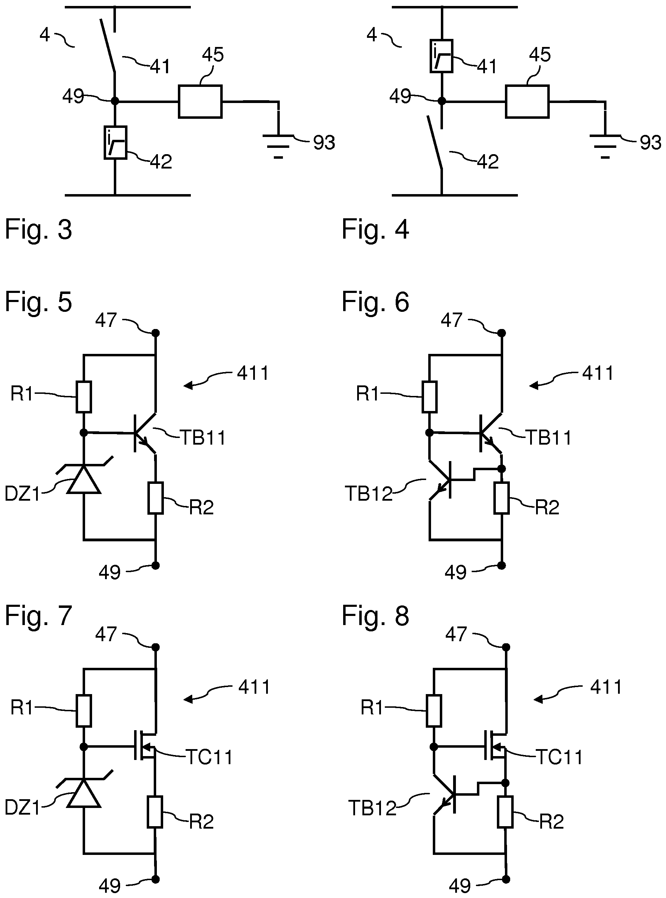

Comme illustré à la figure 3, pour tester l'isolement entre la borne +Vbat de la batterie 2 et la masse mécanique 93, le circuit de commande 8 ouvre la fonction interrupteur dans le circuit de limitation de courant 41 et ferme la fonction interrupteur dans le circuit de limitation de courant 42. Le circuit de détection de courant 45 est alors connecté en série avec le circuit de limitation de courant 42 entre la borne -Vbat et la masse mécanique 93. En cas de défaut d'isolement côté +Vbat, un circuit se forme par l'intermédiaire du défaut d'isolement entre la borne +Vbat et la masse 93. Le courant de défaut d'isolement traversant le circuit 45 peut-être une fonction linéaire de l'amplitude du défaut d'isolement mais ce courant de défaut d'isolement est limité par le circuit 42. Lorsque la valeur de la résistance de défaut d'isolement est suffisamment élevée, le courant de défaut d'isolement traversant le circuit de limitation 42 fermé est inférieur à la limite de courant défini par ce circuit de limitation.

Comme illustré à la figure 4, pour tester l'isolement entre la borne -Vbat de la batterie 2 et la masse mécanique 93, le circuit de commande 8 ouvre la fonction interrupteur dans le circuit de limitation de courant 42 et ferme la fonction interrupteur dans le circuit de limitation de courant 41. Le circuit de détection de courant 45 est alors connecté en série avec le circuit de limitation de courant 41 entre la borne +Vbat et la masse mécanique 93. En cas de défaut d'isolement côté -Vbat, un circuit se forme par l'intermédiaire du défaut d'isolement entre la borne -Vbat et la masse 93. Le courant de défaut d'isolement traversant le circuit 45 peut-être une fonction linéaire de l'amplitude du défaut d'isolement mais ce courant de défaut d'isolement est limité par le circuit 41. Lorsque la valeur de la résistance de défaut d'isolement est suffisamment élevée, le courant de défaut d'isolement traversant le circuit de limitation fermé est inférieur à la limite de courant défini par ce circuit de limitation.

La figure 5 illustre une première variante d'une fonction de limitation de courant 411 (l'homme du métier peut bien entendu réaliser une fonction de limitation de courant 421 similaire). Cette fonction de limitation de courant 411 comporte un transistor bipolaire NPN TB11 dont le collecteur est connecté à la borne 47. Une résistance de polarisation R1 est connectée entre le collecteur et la base du transistor TB11. Une résistance R2 est connectée entre l'émetteur du transistor TB11 et le point intermédiaire 49. Une diode zener DZ1 est connectée entre le point intermédiaire et la base du transistor TB11.

La diode Zener DZ1 permet de façon connue en soi de maintenir une tension sensiblement constante entre la base et le point intermédiaire 49. La résistance de polarisation R1 permet de rendre le transistor TB11 passant en présence d'un courant entre la borne 47 et le point intermédiaire 49 et de polariser DZ1. L'intensité maximale Imax correspond sensiblement à l'intensité traversant le transistor TB11 et peut donc s'exprimer par la relation suivante :

$$Imax=(Vz-Vbe)/R2$$

Avec Vz la tension de claquage de la diode zener, Vbe la tension entre la base et l'émetteur transistor TB11 et R2 la valeur de la résistance R2.

La résistance R1 a pour fonction de limiter au maximum le courant dans cette branche tout en pouvant polariser le transistor TB11 et la diode zener DZ1. A cet effet, la résistance R1 pourra avantageusement présenter une résistance comprise entre $100k\Omega$ et $5M\Omega$. La diode DZ1 présentera avantageusement une tension de claquage comprise entre 5 et 20V, par exemple de 15V. Avec de telles valeurs, la résistance R2 présentera typiquement une valeur de $7 K\Omega$ pour limiter l'intensité maximale traversant le circuit 41 à 2mA lors d'un court-circuit de défaut d'isolement.

La figure 6 illustre une seconde variante d'une fonction de limitation de courant 411. Cette fonction de limitation de courant comporte un transistor bipolaire NPN TB11 dont le collecteur est connecté à la borne 47. Une résistance de polarisation R1 est connectée entre le collecteur et la base du transistor TB11. Une résistance R2 est connectée entre l'émetteur du transistor TB11 et le point intermédiaire 49. Un transistor bipolaire NPN TB12 a son collecteur connecté à la base du transistor TB11, sa base connectée à l'émetteur du transistor TB11, et son émetteur connecté au point intermédiaire 49.

L'intensité maximale Imax correspond sensiblement à l'intensité traversant le transistor TB11 et peut donc s'exprimer par la relation suivante :

$$Imax=(Vbe)/R2$$

(Vbe étant ici la tension base/émetteur du transistor TB12)

La figure 7 illustre une troisième variante d'une fonction de limitation de courant 411. Cette fonction de limitation de courant comporte un transistor MOSFET TC11 dont le drain est connecté à la borne 47. Une résistance de polarisation R1 est connectée entre le drain et la grille du transistor TC11. Une résistance R2 est connectée entre la source du transistor TC11 et le point intermédiaire 49. Une diode zener DZ1 est connectée entre le point intermédiaire et la grille du transistor TC11.

La diode Zener DZ1 permet de façon connue en soi de maintenir une tension sensiblement constante entre la grille et le point intermédiaire 49. La résistance de polarisation R1 permet de rendre le transistor TC11 passant en présence d'un courant entre la borne 47 et le point intermédiaire 49. L'intensité maximale Imax correspond sensiblement à l'intensité traversant le transistor TC11 et peut donc s'exprimer par la relation suivante :

$$Imax=(Vz-Vgsth)/R2$$

Avec Vz la tension de claquage de la diode zener, Vgsth la tension seuil grille/source du transistor TC11 et R2 la valeur de la résistance R2.

La figure 8 illustre une quatrième variante d'une fonction de limitation de courant 411. Cette fonction de limitation de courant comporte un transistor MOSFET TC11 dont le drain est connecté à la borne 47. Une résistance de polarisation R1 est connectée entre le drain et la grille du transistor TC11. Une résistance R2 est connectée entre la source du transistor TC11 et le point intermédiaire 49. Un transistor bipolaire NPN TB12 a son collecteur connecté à la grille du transistor TC11, sa base connectée à la source du transistor TC11, et son émetteur connecté au point intermédiaire 49.

L'intensité maximale Imax correspond sensiblement à l'intensité traversant le transistor TC11 et peut donc s'exprimer par la relation suivante :

$$I=(Vbe)/R2$$

Avec Vbe la tension base/émetteur du transistor TB12.

Les sources de courant présentées avec des transistors NPN et des Mosfets canal N peuvent aussi être réalisées avec des transistors PNP et des MOS canal P.

Même si les fonctions de limitation de courant décrites atteignent une saturation et ne permettent pas de déterminer l'amplitude du courant de défaut d'isolement au-delà d'un certain seuil, cela ne nuit pas au fonctionnement du dispositif de détection 4, celui-ci conservant encore sa fonction de détecter l'apparition du défaut d'isolement et éventuellement analyser son évolution initiale.

Dans les variantes des figures 5 à 8, la fonction d'interrupteur 412 est en configuration de test et donc fermée. La fonction de limitation de courant 411 est donc illustrée connectée entre la borne 47 et le point intermédiaire 49.

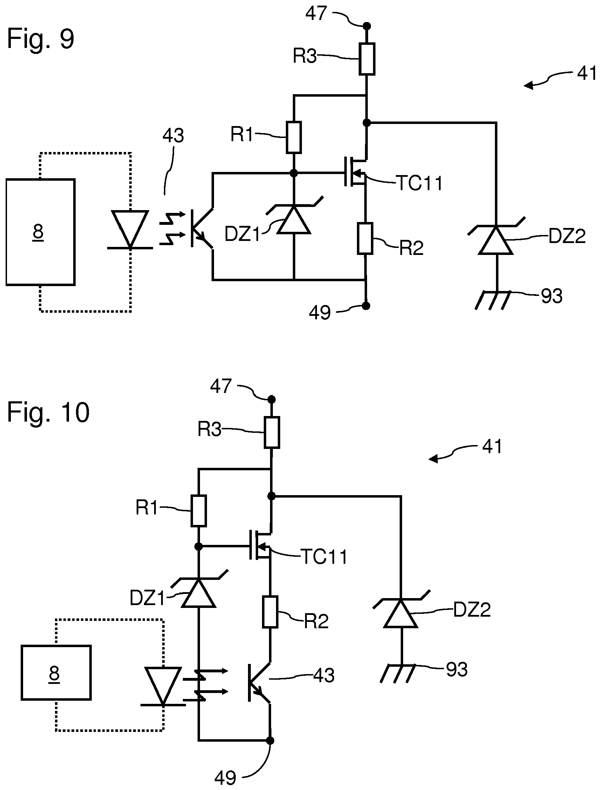

La figure 9 illustre un exemple de circuit de limitation de courant 41 intégrant une fonction de limitation de courant 411 selon la troisième variante. Le circuit de limitation de courant 41 comprend un interrupteur réalisé sous la forme d'un optocoupleur 43. L'optocoupleur 43 comprend un phototransistor dont le collecteur est connecté à la grille du transistor TC11 et dont l'émetteur est connecté au point intermédiaire 49.

Une résistance de protection R3 est connectée entre le drain du transistor TC11 et la borne 47. Une diode zener de protection DZ2 est connectée entre le drain du transistor TC11 et la masse mécanique 93. Ceci sert à la protection contre les surtensions issues du réseau, notamment lors de l'utilisation d'un chargeur non isolé pour améliorer la robustesse du système.

La fonction d'interrupteur du circuit de limitation de courant 41 est ici réalisée au moyen de l'optocoupleur 43. Par une commande appropriée, le circuit de commande 8 rend le phototransistor de l'optocoupleur 43 passant ou bloqué. À l'état passant, le phototransistor maintient le transistor TC11 bloqué, assurant ainsi une fonction d'interrupteur ouvert. La fonction d'interrupteur permet de fermer en alternance les circuits de limitation de courant 41 et 42. En effet, comme il est délicat de réaliser des circuits 41 et 42 avec des propriétés suffisamment proches, une fermeture en simultané des circuits 41 et 42 pourrait induire un déséquilibre au niveau du point intermédiaire 49 et ainsi une détection de défaut d'isolement erronée. Par ailleurs, la fonction d'interrupteur permet également de limiter la consommation de courant du dispositif de détection 4 en dehors d'une phase de test : en maintenant les circuits 41 et 42 ouverts avec un rapport cyclique élevé, la consommation du dispositif de détection 4 est particulièrement réduite. Chaque circuit 41 ou 42 sera avantageusement fermé avec une fréquence inférieure à 0,1 Hz (intervalles temporels par exemple compris entre 10 et 30 secondes) et avec un rapport cyclique de fermeture des circuits 41 et 42 de préférence inférieur à 2 % durant le fonctionnement de la source de tension continue.

Les circuits de limitation de courant 41 et 42 seront avantageusement dimensionnés de façon à, lorsque le circuit de commande leur applique une commande de fermeture, rester fermés même lorsqu'ils sont traversés par un courant pour un défaut d'isolement correspondant à un court-circuit entre une borne et la masse. Ce dimensionnement pourra être effectué en fonction du rapport cyclique de fermeture qui leur est appliqué par le circuit de commande 8.

La solution de la figure 9 a pour inconvénient d'induire une consommation dans l'optocoupleur 43 pour maintenir le transistor TC11 bloqué. La solution de la figure 10 propose une alternative permettant de supprimer cette consommation de courant lorsque le circuit de limitation de courant 41 est ouvert. Le circuit de limitation de courant 41 comprend un optocoupleur 43. L'optocoupleur 43 comprend un phototransistor dont le collecteur est connecté à la résistance R2 et dont l'émetteur est connecté au point intermédiaire 49.

La fonction d'interrupteur du circuit de limitation de courant 41 est ici également réalisée au moyen de l'optocoupleur 43. Par une commande appropriée, le circuit de commande 8 rend le phototransistor passant ou bloqué. À l'état bloqué, le phototransistor maintient le transistor TC11 bloqué, assurant ainsi une fonction d'interrupteur ouvert. A l'état passant, le phototransistor peut être traversé par le courant traversant le transistor TC11. Comme dans l'exemple de la figure 9, la fonction d'interrupteur permet de fermer en alternance les circuits de limitation de courant 41 et 42.

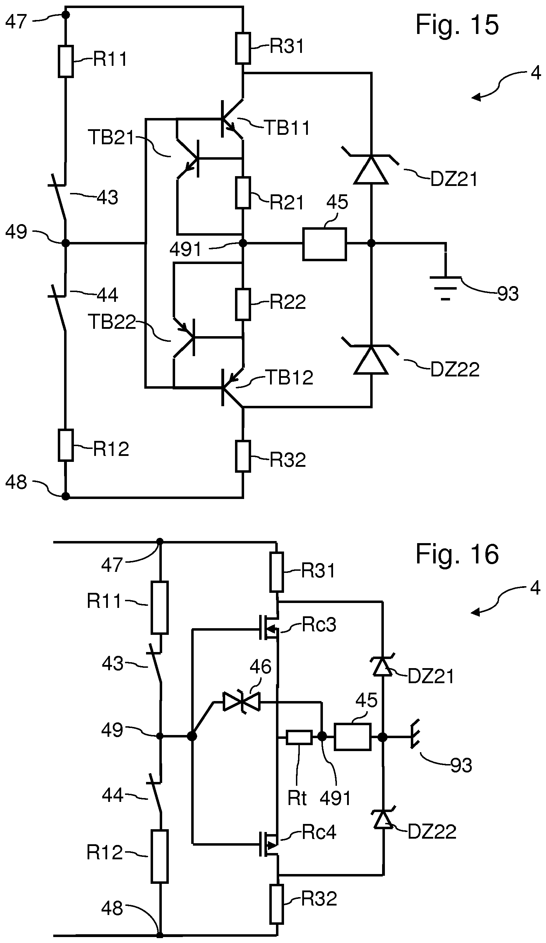

La figure 15 illustre une variante du dispositif de détection 4 munie d'un circuit limiteur de courant de défaut d'isolement combiné à un circuit d'amplification de ce courant. Dans cette variante, le circuit d'amplification du courant de fuite est réalisé à partir de transistors bipolaires.

Le dispositif de détection 4 comporte une première impédance R11 et une deuxième impédance R12 (en l'occurrence des résistances) connectées en série entre la première borne 47 et la deuxième borne 48. Les impédances R11 et R12 sont connectées par l'intermédiaire du point intermédiaire 49 et sont de préférence de valeurs sensiblement identiques. Un premier interrupteur 43 est connecté en série avec la première impédance R11 entre la borne 47 et le point intermédiaire 49. Un deuxième interrupteur 44 est connecté en série avec la deuxième impédance R12 entre la deuxième borne 48 et le point intermédiaire 49. Les interrupteurs 43 et 44 sont en l'occurrence des transistors MOSFET. D'autres types d'interrupteurs commandés peuvent bien entendu être utilisés. Le circuit de commande 8 commande l'ouverture/fermeture respective des interrupteurs 43 et 44. Le circuit de commande 8 maintient l'interrupteur 43 ouvert lorsqu'il procède à la fermeture de l'interrupteur 44 lors d'une phase de test, et réciproquement.

Le circuit d'amplification comprend un transistor bipolaire NPN TB11 dont la base est connectée au point intermédiaire 49, un transistor bipolaire NPN TB21 dont le collecteur est connecté au point intermédiaire 49, dont la base est connectée à l'émetteur du transistor TB11, et dont l'émetteur est connecté à l'entrée 491 du circuit de détection 45. Une résistance de gain R21 est connectée entre la base et l'émetteur du transistor TB21. Une résistance de protection R31 est avantageusement connectée entre le collecteur du transistor TB11 et la borne 47.

Le circuit d'amplification comprend également un transistor bipolaire PNP TB12 dont la base est connectée au point intermédiaire 49, un transistor bipolaire PNP TB22 dont le collecteur est connecté au point intermédiaire 49, dont la base est connectée à l'émetteur du transistor TB12, et dont l'émetteur est connecté à l'entrée 491 du circuit de détection 45. Une résistance de gain R22 est connectée entre la base et l'émetteur du transistor TB22. Une résistance de protection R32 est avantageusement connectée entre le collecteur du transistor TB12 et la borne 48.

Le circuit d'amplification comprend avantageusement en outre des diodes Zener DZ21 et DZ22 connectées respectivement entre le collecteur de TB11 et la masse mécanique 93 et entre le collecteur de TB12 et la masse mécanique 93.

Les transistors TB11 et TB12 sont destinés à amplifier le courant traversant les impédances R11 et R12 pour augmenter la gamme de mesure. Les transistors TB21 et TB22 sont destinés à limiter le courant de défaut d'isolement pour assurer la protection des usagers. Il n'est pas possible avec des impédances R11 et R12 seules d'avoir à la fois une gamme de mesure étendue et une protection satisfaisante des usagers. Les résistances de protection R31 et R32 ainsi que les diodes Zener DZ21 et DZ22 permettent de protéger les transistors TB11, TB12, TB21 et TB22 du circuit d'amplification contre les surtensions en particulier lors de l'utilisation d'un chargeur non isolé qui applique directement les surtensions issues du réseau.

La figure 16 illustre une autre variante du dispositif de détection 4 munie d'un circuit limiteur de courant de défaut d'isolement combiné à un circuit d'amplification de ce courant. Dans cette variante, le circuit d'amplification du courant de fuite est réalisé à partir de transistors MOS.

Le dispositif de détection 4 comporte une première impédance R11 et une deuxième impédance R12 connectées en série entre la première borne 47 et la deuxième borne 48. Les impédances R11 et R12 sont connectées par l'intermédiaire du point intermédiaire 49 et sont de préférence de valeurs sensiblement identiques. Un premier interrupteur 43 est connecté en série avec la première impédance R11 entre la borne 47 et le point intermédiaire 49. Un deuxième interrupteur 44 est connecté en série avec la deuxième impédance R12 entre la deuxième borne 48 et le point intermédiaire 49. Le circuit de commande 8 commande l'ouverture/fermeture respective des interrupteurs 43 et 44. Le circuit de commande 8 maintient l'interrupteur 43 ouvert lorsqu'il procède à la fermeture de l'interrupteur 44 lors d'une phase de test, et réciproquement.

Le circuit d'amplification comprend un couple de diodes Zener 46 montées en série tête-bêche ou une diode zener bidirectionnelle entre le point intermédiaire 49 et l'entrée 491 du circuit de détection 45.

Le circuit d'amplification comprend un transistor MOS canal N Rc3 dont la grille est connectée au point intermédiaire 49. Le circuit d'amplification comprend avantageusement également une résistance de protection R31 connectée entre la borne 47 et le drain du transistor Rc3.

Le circuit d'amplification comprend un transistor MOS canal P Rc4 dont la grille est connectée au point intermédiaire 49. Le circuit d'amplification comprend avantageusement également une résistance de protection R32 connectée entre la borne 48 et le drain du transistor Rc4.

Le circuit d'amplification comprend une résistance Rt d'atténuation de courant connectée entre l'entrée 491 et la source des transistors Rc3 et Rc4.

Le circuit d'amplification comprend avantageusement en outre des diodes Zener DZ21 et DZ22 connectées respectivement entre le drain des transistors Rc3 et Rc4 et la masse mécanique 93. Celles-ci protègent le circuit des surtensions en particulier lors de l'utilisation d'un chargeur non isolé qui applique directement les surtensions issues du réseau. La diode Zener bidirectionnelle (ou le couple de diodes tête-bêche) 46 permet de limiter l'intensité à travers le circuit de détection 45 à une valeur Imax définie par la relation suivante :

$$Imax = (Vz - Vgsth)/Rt$$

Avec Rt la valeur de résistance de Rt, Vz la tension de seuil du couple ou de la diode zener bidirectionnelle 46 (ou du couple de diodes tête-bêche) et Vgsth la différence de potentiel entre la grille et la source d'un des transistors Rc3 ou Rc4.

Lors d'une phase de test et en présence d'un défaut d'isolement, la tension sur la grille du transistor Rc3 ou Rc4 est suffisante pour le rendre passant. Le courant traversant le transistor rendu passant traverse la résistance Rt et le circuit de détection 45. On réalise ainsi une amplification du courant de défaut d'isolement appliqué sur l'entrée 491 du circuit de détection 45. Le courant maximum de défaut est limité par la résistance Rt et la diode zener bidirectionnelle 46 (ou le couple de diodes tête-bêche) pour la sécurité du matériel et des personnes.

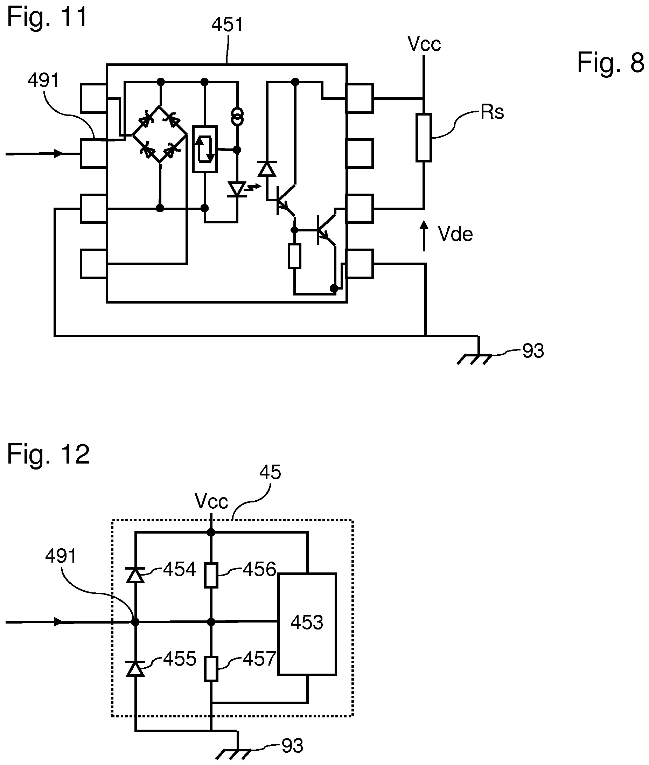

La figure 11 représente un exemple de circuit de détection sous forme de photocoupleur à hystérésis 451 (de structure connue en soi), permettant de détecter un courant de défaut d'isolement lorsque celui-ci franchit un seuil. Lorsque le courant à l'entrée de 491 franchit un seuil défini pour le photocoupleur à hysteresis 451, le photocoupleur 451 génère un signal de détection d'un défaut d'isolement Vde, lu par le circuit de commande 8.

La figure 12 illustre un autre exemple de détection de défaut d'isolement, permettant de déterminer l'amplitude du courant de défaut d'isolement, et ainsi d'analyser son évolution dans le temps. Le circuit de détection 45 inclut un microcontrôleur 453. Le microcontrôleur 453 est connecté à l'entrée 491, au potentiel Vcc et à la masse mécanique 93. La tension Vcc peut être dérivée de la batterie 91. Une diode 454 et une résistance 456 sont connectées en parallèle entre Vcc et l'entrée 491. Une diode 455 et une résistance 457 sont connectées en parallèle entre la masse mécanique 93 et l'entrée 491. Les résistances 456 et 457 sont de mêmes valeurs. Sans courant de défaut d'isolement, la tension sur l'entrée 491 est à la valeur Vcc/2. Tout courant de défaut modifie la tension sur l'entrée 491. En fonction de la valeur de tension lue sur l'entrée 491, le microcontrôleur 453 peut déterminer précisément l'amplitude du défaut d'isolement. La valeur de tension lue sur l'entrée 491 peut être fournie au circuit de contrôle 8.

La figure 13 illustre une variante d'un dispositif de détection 4 permettant de tester son fonctionnement. À cet effet, le dispositif de détection 4 comprend deux condensateurs C1 et C2 connectés entre les bornes +Vbat et -Vbat et la masse mécanique 93.

Lorsque le circuit de commande 8 ferme le circuit de limitation de courant 41, un courant de décharge du condensateur C1 traverse transitoirement le circuit de détection 45, avant que celui-ci puisse mesurer un éventuel courant de défaut d'isolement. Le circuit de commande 8 peut ainsi identifier que le circuit de détection 4 est fonctionnel en vérifiant la présence du courant de décharge transitoire.

Lorsque le circuit de commande 8 ferme le circuit de limitation de courant 42, un courant de décharge du condensateur C2 traverse transitoirement le circuit de détection 45, avant que celui-ci puisse mesurer un éventuel courant de défaut d'isolement. Le circuit de commande 8 peut ainsi identifier que le circuit de détection 4 est fonctionnel en vérifiant la présence du courant de décharge transitoire.

De tels condensateurs peuvent déjà être intégrés pour d'autres fonctions dans l'architecture électrique, par exemple pour filtrer les perturbations de mode commun à l'intérieur de l'onduleur 6 ou dans un convertisseur d'énergie. Dans ce cas aucun composant additionnel n'est nécessaire. Ces condensateurs peuvent également être complétés par les capacités parasites internes aux différents circuits.

Le temps de décharge de ces condensateurs peut également servir pour estimer la valeur de ces condensateurs et éventuellement leur dérive dans le temps.

Dans les installations électriques en alternatif, les régimes de neutre les plus courants sont :

- le régime TT : le neutre de l'installation est relié à la terre coté générateur et les masses métalliques sont reliées à la terre;
- le régime TN : le neutre de l'installation est relié à la terre coté générateur et les masses métalliques sont reliées au neutre ;

- le régime IT : le neutre de l'installation est isolé de la terre ou relié par une impédance élevée coté générateur et les masses métalliques sont reliées à une prise de terre.

Le régime de neutre définit ainsi la façon dont le neutre est raccordé d'une part, et la façon dont les masses sont raccordées côté utilisateur d'autre part. Les schémas de liaison à la terre ont pour but de protéger les personnes et le matériel en maîtrisant les défauts d'isolement.

Le schéma de liaison à la terre de la batterie 2 est assimilable à un régime de neutre IT d'un réseau électrique, c'est-à-dire un neutre isolé par rapport à la terre et une masse mécanique raccordée à la terre (sauf en roulage où la masse mécanique est isolée de la terre par l'intermédiaire des pneumatiques). Un tel schéma de liaison à la terre permet d'assurer la continuité de service du véhicule lors de l'apparition d'un premier défaut d'isolement. L'utilisateur peut ainsi continuer à contrôler le véhicule pour l'arrêter dans de bonnes conditions de sécurité.

Pour assurer la recharge de la batterie 2 par un réseau électrique, on raccorde généralement un chargeur isolé à courant alternatif connecté sur le réseau. Dans ce cas le régime IT est conservé. Par contre, un chargeur isolé galvaniquement est plus cher qu'un chargeur non isolé. Avec un chargeur non isolé, on se retrouve en régime TT durant la charge, ce qui revient à connecter la terre au potentiel -Vbat de la batterie 2 lors des alternances positives du réseau électrique. Un courant transite alors par la terre durant ces alternances.

Pour éviter un faux positif par le dispositif de détection 4 lors d'une charge rapide de la batterie, on désactive alors le contrôle d'isolement sur la borne -Vbat de la batterie 2 par l'ouverture des deux interrupteurs 41 et 42.

Dans les exemples illustrés aux figures 9 et 10, le circuit de limitation de courant 41 est protégé d'éventuelles surtensions pouvant être induites par un chargeur non isolé, par l'intermédiaire de la résistance R3 et par l'intermédiaire de la diode zener ou diode transil DZ2. Les règles de dimensionnement de ces composants de protection peuvent être les suivantes. Avec une batterie 2 dont la tension nominale et 400 V, on pourra utiliser des composants de la fonction limitation de courant 411 prévus pour résister à des tensions de 600 V. Si l'on souhaite protéger le circuit de limitation 41 contre une surtension de 4 kV (qui peut par exemple être due à l'effet de la foudre sur le réseau d'alimentation d'un chargeur non isolé), la tension aux bornes de la diode DZ2 doit donc rester inférieure à 600 V. Pour une telle surtension, la tension aux bornes de la résistance R3 sera donc de 3,4 kV. Avec une diode DZ2 dimensionnée pour une puissance de 600W, l'intensité la traversant doit être inférieure à 1 A. Par conséquent, la résistance R3 doit être au moins égale à 3,4 kΩ.

Si le transistor TC11 supporte l'énergie de surtension en avalanche, on peut se dispenser d'utiliser la diode DZ2.

La résistance R3 est également utile pour limiter le courant dans l'hypothèse d'une destruction du transistor TC11. Bien que ces protections aient été décrites en combinaison avec la solution de la troisième variante, ces protections sont bien entendu utilisables dans les première, deuxième et quatrième variantes.

## Revendications

1.　Dispositif d'alimentation électrique, comprenant :

- une source de tension continue susceptible d'induire une électrocution (2) ;
- un dispositif de détection (4) d'un défaut d'isolement de la source de tension continue, comprenant :

- des première et deuxième bornes d'entrée (47, 48) connectées aux bornes de la source de tension;
- un premier circuit (41) connecté entre la première borne d'entrée (47) et un point intermédiaire (49) ;
- un deuxième circuit (42) connecté entre la deuxième borne d'entrée (48) et ledit point intermédiaire ;
- un circuit de détection de courant (45) de défaut d'isolement connecté entre une masse électrique et ledit point intermédiaire (49) ;

caractérisé en ce que lesdits premier et deuxième circuits sont des limiteurs de courant,

- le premier circuit limiteur de courant présentant une impédance sensiblement constante lorsque la tension à ses bornes est inférieure à une tension de saturation, et présentant une impédance Z1 proportionnelle à la tension Vb1 à ses bornes lorsque cette tension est supérieure audit seuil de saturation de façon à être traversé par un courant I1=Vb1/Z1,
- le deuxième circuit limiteur de courant présentant une impédance sensiblement constante lorsque la tension à ses bornes est inférieure à une tension de saturation, et présentant une impédance Z2 proportionnelle à la tension Vb2 à ses bornes lorsque cette tension est supérieure audit seuil de saturation de façon à être traversé par un courant I2=Vb2/Z2,

lesdits limiteurs de courant étant configurés pour ouvrir et fermer sélectivement la connexion entre leur borne d'entrée respective et le point intermédiaire, chacun desdits circuits limiteurs de courant étant dimensionné pour être traversé par un courant inférieur à un seuil de sécurité normé lorsque le premier ou le deuxième circuit limiteur de courant est fermé et que l'une des bornes de la source de tension continue est court-circuitée à la masse électrique, le seuil de sécurité normé étant supérieur aux valeurs I1 et I2 ;

en outre **caractérisé en ce qu'**il comprend un circuit de commande (8) configuré pour :

- tester l'isolement entre la première borne d'entrée et la masse en maintenant simultanément ledit premier circuit limiteur de courant ouvert et ledit deuxième circuit limiteur de courant fermé pour connecter le circuit de détection de défaut d'isolement en série avec le deuxième circuit limiteur de courant entre la deuxième borne d'entrée et la masse,

- tester l'isolement entre la deuxième borne d'entrée et la masse en maintenant simultanément ledit premier circuit limiteur de courant fermé et ledit deuxième circuit limiteur de courant ouvert, pour connecter le circuit de détection de défaut d'isolement en série avec le premier circuit limiteur de courant entre la première borne d'entrée et la masse.

2. Dispositif d'alimentation électrique selon la revendication 1, dans lequel chacun desdits circuits limiteurs de courant comprend un optocoupleur (43) commandé par le circuit de commande (8) de façon à ouvrir et fermer sélectivement la connexion dans son circuit limiteur de courant respectif.

3. Dispositif d'alimentation électrique selon la revendication 1 ou 2, comprenant un premier condensateur (C1) connecté en parallèle du premier circuit limiteur de courant entre la première borne d'entrée et la masse électrique (93), un deuxième condensateur (C2) connecté en parallèle du deuxième circuit limiteur de courant entre la deuxième borne d'entrée et la masse électrique, le circuit de commande (8) étant configuré pour détecter la décharge d'un desdits condensateurs lors de la fermeture de la connexion d'un desdits circuits limiteurs de courant.

4. Dispositif d'alimentation électrique selon l'une quelconque des revendications précédentes, dans lequel le circuit de commande (8) ferme chacun des circuits limiteurs de courant de façon répétée avec un intervalle temporel compris entre 10 et 30 secondes.

5. Dispositif d'alimentation électrique selon l'une quelconque des revendications précédentes, dans lequel le circuit de commande (8) maintient lesdits circuits limiteurs de courant (41,42) fermés avec un rapport cyclique inférieur à 2 %.

6. Dispositif d'alimentation électrique selon l'une quelconque des revendications précédentes, dans lequel le circuit de détection de courant (45) comprend un microcontrôleur (453) comportant une borne d'entrée (491) recevant le courant de défaut d'isolement provenant du point intermédiaire (49), ladite borne d'entrée étant connectée à une alimentation par l'intermédiaire d'une première résistance (456), ladite borne d'entrée étant par ailleurs connectée à la masse électrique (93) par l'intermédiaire d'une deuxième résistance (457), ladite alimentation étant à un niveau de tension au moins dix fois inférieur au niveau de tension de la source de tension continue, ledit microcontrôleur (453) étant configuré pour déterminer l'amplitude d'un défaut d'isolement en fonction de la tension appliquée sur sa borne d'entrée.

7. Dispositif d'alimentation électrique selon l'une quelconque des revendications précédentes, dans lequel chaque circuit limiteur de courant comprend :

- un premier transistor comportant une électrode d'entrée connectée à une borne d'entrée respective du dispositif de détection, une électrode de sortie et une électrode de commande ;
- une première résistance (R1) connectée entre l'électrode d'entrée et l'électrode de commande ;
- une deuxième résistance (R2) connectée entre l'électrode de sortie et le point intermédiaire (49) ;
- un organe de limitation du niveau de tension sur l'électrode de commande.

8. Dispositif d'alimentation électrique selon la revendication 7, dans lequel ledit premier transistor est un transistor MOSFET (TC11).

9. Dispositif d'alimentation électrique selon la revendication 7 ou 8, dans lequel l'organe de limitation du niveau de tension est une diode zener connectée entre l'électrode de commande du premier transistor et le point intermédiaire.

10. Dispositif d'alimentation électrique selon la revendication 7 ou 8, dans lequel l'organe de limitation du niveau de tension est un transistor bipolaire dont la base est connectée à l'électrode de sortie du premier transistor, dont l'émetteur est connecté au point intermédiaire et dont le collecteur est connecté à l'électrode de commande du premier transistor.

**11.** Dispositif d'alimentation électrique selon l'une quelconque des revendications précédentes, dans lequel chacun desdits circuits limiteurs de courant est dimensionné pour être traversé par un courant inférieur à 3.5mA lorsque le premier ou le deuxième circuit limiteur de courant est fermé et que l'une des bornes de la source de tension continue est court-circuitée à la masse électrique.

**12.** Dispositif d'alimentation électrique selon l'une quelconque des revendications précédentes, dans lequel chacun desdits circuits limiteurs de courant est dimensionné de façon à, lorsque le circuit de commande lui applique une commande de fermeture, rester fermé lorsqu'il est traversé par un courant induit par un court-circuit entre l'une des bornes de la source de tension continue et la masse électrique.

**13.** Système de motorisation (1), comprenant :

- un dispositif d'alimentation électrique selon l'une quelconque des revendications précédentes, dans lequel la source de tension continue est une batterie ;
- un onduleur (6) présentant une interface continu et une interface alternatif, les bornes de la batterie étant connectées à l'interface continu ;
- un moteur électrique (7) connecté à l'interface alternatif de l'onduleur (6).

**14.** Système de motorisation selon la revendication 13, dans lequel la tension aux bornes de la batterie (2) est supérieure à 100 V.

**15.** Véhicule automobile (1) comprenant un système de motorisation selon la revendication 13 ou 14.

**Patentansprüche**

**1.** Stromversorgungsvorrichtung, die Folgendes umfasst:

- eine Gleichspannungsquelle, die eine Elektrokution (2) induzieren kann;
- eine Erfassungsvorrichtung (4) eines Isolationsfehlers der Gleichspannungsquelle, die Folgendes umfasst:
- eine erste und eine zweite Eingangsklemme (47, 48), die an Klemmen der Spannungsquelle angeschlossen sind;
- eine erste Schaltung (41), die zwischen der ersten Eingangsklemme (47) und einem Zwischenpunkt (49) verbunden ist;
- eine zweite Schaltung (42), die zwischen der zweiten Eingangsklemme (48) und dem Zwischenpunkt verbunden ist;
- eine Isolationsfehler-Stromerfassungsschaltung (45), die mit einer elektrischen Masse und dem Zwischenpunkt (49) verbunden ist;

**dadurch gekennzeichnet, dass** die erste und die zweite Schaltung Strombegrenzer sind,

- wobei der erste Strombegrenzer eine im Wesentlichen konstante Impedanz aufweist, wenn die Spannung an seinen Klemmen kleiner ist als eine Sättigungsspannung, und eine Impedanz Z1 proportional zu der Spannung Vb1 an seinen Klemmen aufweist, wenn diese Spannung größer ist als die Sättigungsschwelle, so dass er von einem Strom I1=Vb1/Z1 durchquert wird,
- wobei der zweite Strombegrenzer eine im Wesentlichen konstante Impedanz aufweist, wenn die Spannung an seinen Klemmen kleiner ist als eine Sättigungsspannung, und eine Impedanz Z2 proportional zu der Spannung Vb2 an seinen Klemmen aufweist, wenn diese Spannung größer ist als die Sättigungsspannung, so dass er von einem Strom I2=Vb2/Z2 durchquert wird,

wobei die Strombegrenzer konfiguriert sind, um selektiv die Verbindung zwischen ihrer jeweiligen Eingangsklemme und dem Zwischenpunkt zu öffnen und zu schließen, wobei jede der Strombegrenzungsschaltungen bemessen ist, um von einem Strom durchquert zu werden, der kleiner ist als ein genormter Sicherheitsschwellenwert, wenn die erste oder die zweite Strombegrenzungsschaltung geschlossen ist, und dass eine der Klemmen der Gleichspannungsquelle zu der elektrischen Masse kurzgeschaltet wird, wobei der Sicherheitsschwellenwert größer ist als die Werte I1 und I2; außerdem **dadurch gekennzeichnet, dass** sie eine Steuerschaltung (8) umfasst, die konfiguriert ist, um:

- die Isolation zwischen der ersten Eingangsklemme und der Masse zu testen, indem gleichzeitig die erste Strombegrenzungsschaltung offen und die zweite Strombegrenzungsschaltung geschlossen gehalten wird, um die Isolationsfehler-Stromerfassungsschaltung mit der zweiten Strombegrenzungsschaltung zwischen der zweiten Eingangsklemme und der Masse in Serienschaltung zu verbinden,
- die Isolation zwischen der zweiten Eingangsklemme und der Masse zu testen, indem gleichzeitig die erste Strombegrenzungsschaltung geschlossen und die zweite Strombegrenzungsschaltung offen gehalten wird, um die Isolationsfehler-Stromerfassungsschaltung zwischen der ersten Eingangsklemme und der Masse in Serienschaltung zu verbinden.

**2.** Stromversorgungsvorrichtung nach Anspruch 1, wobei jede der Strombegrenzungsschaltungen einen Optokoppler (43) umfasst, der von der Steuerschaltung (8) derart gesteuert wird, dass selektiv die Verbindung in seiner jeweiligen Strombegrenzungsschaltung geöffnet und geschlossen wird.

3. Stromversorgungsvorrichtung nach Anspruch 1 oder 2, die einen ersten Kondensator (C1) umfasst, der mit der ersten Strombegrenzungsschaltung zwischen der ersten Eingangsklemme und der elektrischen Masse (93) parallel geschaltet ist, einen zweiten Kondensator (C2), der mit der zweiten Strombegrenzungsschaltung zwischen der zweiten Eingangsklemme und der elektrischen Masse parallel geschaltet ist, wobei die Steuerschaltung (8) konfiguriert ist, um das Entladen eines der Kondensatoren beim Schließen der Verbindung einer der Strombegrenzungsschaltungen zu erfassen.

4. Stromversorgungsvorrichtung nach einem der vorhergehenden Ansprüche, wobei die Steuerschaltung (8) jede der Strombegrenzungsschaltungen wiederholt mit einem Zeitintervall zwischen 10 und 30 Sekunden schließt.

5. Stromversorgungsvorrichtung nach einem der vorhergehenden Ansprüche, wobei die Steuerschaltung (8) die Strombegrenzungsschaltungen (41, 42) mit einem zyklischen Verhältnis kleiner als 2 % geschlossen hält.

6. Stromversorgungsvorrichtung nach einem der vorhergehenden Ansprüche, wobei die Isolationsfehler-Stromerfassungsschaltung (45) einen Mikrocontroller (453) umfasst, der eine Eingangsklemme (491) umfasst, die den Isolationsfehlerstrom empfängt, der von dem Zwischenpunkt (49) kommt, wobei die Eingangsklemme mit einer Versorgung über einen ersten Widerstand (456) verbunden ist, wobei die Eingangsklemme außerdem mit der elektrischen Masse (93) über einen zweiten Widerstand (457) verbunden ist, wobei die Versorgung an einem Spannungspegel ist, der zehn Mal kleiner ist als der Spannungspegel der Gleichstromspannungsquelle, wobei der Mikrocontroller (453) konfiguriert ist, um die Amplitude eines Isolationsfehlers in Abhängigkeit von der Spannung, die an seine Eingangsklemme angelegt wird, zu bestimmen.

7. Stromversorgungsvorrichtung nach einem der vorhergehenden Ansprüche, wobei jede Strombegrenzungsschaltung Folgendes umfasst:

- einen ersten Transistor, der eine Eingangselektrode umfasst, die mit einer jeweiligen Eingangsklemme der Erfassungsvorrichtung verbunden ist, eine Ausgangselektrode und eine Steuerelektrode;
- einen ersten Widerstand (R1), der zwischen der Eingangselektrode und der Steuerelektrode verbunden ist;
- einen zweiten Widerstand (R2), der mit der Ausgangselektrode und dem Zwischenpunkt (49) verbunden ist;
- ein Begrenzungselement des Spannungspegels auf der Steuerelektrode.

8. Stromversorgungsvorrichtung nach Anspruch 7, wobei der erste Transistor ein MOSFET (TC11) ist.

9. Stromversorgungsvorrichtung nach Anspruch 7 oder 8, wobei das Begrenzungselement des Spannungspegels eine Zenerdiode ist, die mit der Steuerelektrode des Ersten Transistors und dem Zwischenpunkt verbunden ist.

10. Stromversorgungsvorrichtung nach Anspruch 7 oder 8, wobei das Begrenzungselement des Spannungspegels ein Bipolartransistor ist, dessen Basis mit der Ausgangselektrode des ersten Transistors verbunden ist, dessen Sender mit dem Zwischenpunkt verbunden ist, und dessen Kollektor mit der Steuerelektrode des ersten Transistors verbunden ist.

11. Stromversorgungsvorrichtung nach einem der vorhergehenden Ansprüche, wobei jede der Strombegrenzungsschaltungen bemessen ist, um von einem Strom kleiner als 3,5 mA durchquert zu werden, wenn die erste oder die zweite Strombegrenzungsschaltung geschlossen ist, und eine der Klemmen der Gleichstromquelle der elektrischen Masse kurzgeschaltet ist.

12. Stromversorgungsvorrichtung nach einem der vorhergehenden Ansprüche, wobei jede der Strombegrenzungsschaltungen derart bemessen ist, dass sie, wenn ein Schließbefehl an sie anlegt wird, geschlossen bleibt, bis sie von einem Strom durchquert wird, der von einem Kurzschluss zwischen einer der Klemmen der Gleichspannungsquelle und der elektrischen Masse induziert wird.

13. Antriebssystem (1), das Folgendes umfasst:

- eine Stromversorgungsvorrichtung nach einem der vorhergehenden Ansprüche, wobei die Gleichstromquelle eine Batterie ist;
- einen Wechselrichter (6), der eine Gleichstromschnittstelle und eine Wechselstromschnittstelle aufweist, wobei die Klemmen der Batterie mit der Gleichstromschnittstelle verbunden sind;
- einen Elektromotor (7), der mit der Wechselstromschnittstelle des Wechselrichters (6) verbunden ist.

**14.** Antriebssystem nach Anspruch 13, wobei die Spannung an den Klemmen der Batterie (2) größer ist als 100 V.

**15.** Kraftfahrzeug (1), das ein Antriebssystem nach Anspruch 13 oder 14 umfasst.


**Claims**

1. Electrical power supply device, comprising:

   - a DC voltage source liable to induce electrocution (2);
   - a device (4) for detecting an insulation defect of the DC voltage source, comprising:

      - first and second input terminals (47, 48) connected to the terminals of the voltage source;
      - a first circuit (41) connected between the first input terminal (47) and an intermediate point (49);
      - a second circuit (42) connected between the second input terminal (48) and said intermediate point;
      - an insulation defect current-detection circuit (45) connected between an electrical ground and said intermediate point (49);

   **characterized in that** said first and second circuits are current limiters,

      - the first current limiter circuit exhibiting a substantially constant impedance when the voltage across its terminals is less than a saturation voltage, and exhibiting an impedance Z1 proportional to the voltage Vb1 across its terminals when this voltage is greater than said saturation threshold so as to be traversed by a current I1=Vb1/Z1,
      - the second current limiter circuit exhibiting a substantially constant impedance when the voltage across its terminals is less than a saturation voltage, and exhibiting an impedance Z2 proportional to the voltage Vb2 across its terminals when this voltage is greater than said saturation threshold so as to be traversed by a current I2=Vb2/Z2,

   said current limiters being configured to selectively open and close the connection between their respective input terminal and the intermediate point, each of said current limiter circuits being rated so as to be traversed by a current of less than a standardized safety threshold when the first or the second current limiter circuit is closed and one of the terminals of the DC voltage source is short-circuited to the electrical ground, the standardized safety threshold being greater than the values I1 and I2;
furthermore **characterized in that** it comprises a control circuit (8) configured to:

   - test the insulation between the first input terminal and the ground by simultaneously maintaining said first current limiter circuit open and said second current limiter circuit closed so as to connect the insulation defect detection circuit in series with the second current limiter circuit between the second input terminal and the ground,
   - test the insulation between the second input terminal and the ground by simultaneously maintaining said first current limiter circuit closed and said second current limiter circuit open, so as to connect the insulation defect detection circuit in series with the first current limiter circuit between the first input terminal and the ground.

2. Electrical power supply device according to Claim 1, in which each of said current limiter circuits comprises an optocoupler (43) controlled by the control circuit (8) so as to selectively open and close the connection in its respective current limiter circuit.

3. Electrical power supply device according to Claim 1 or 2, comprising a first capacitor (C1) connected in parallel with the first current limiter circuit between the first input terminal and the electrical ground (93), a second capacitor (C2) connected in parallel with the second current limiter circuit between the second input terminal and the electrical ground, the control circuit (8) being configured to detect the discharging of one of said capacitors upon the closing of the connection of one of said current limiter circuits.

4. Electrical power supply device according to any one of the preceding claims, in which the control circuit (8) closes each of the current limiter circuits in a repeated manner with a time interval of between 10 and 30 seconds.

5. Electrical power supply device according to any one of the preceding claims, in which the control circuit (8) keeps said current-limiting circuits (41,42) closed with a duty ratio of less than 2%.

6. Electrical power supply device according to any one of the preceding claims, in which the current-detection circuit (45) comprises a microcontroller (453) comprising an input terminal (491) receiving the insulation defect current originating from the intermediate point (49), said input terminal being connected to a power supply by way of a first resistor (456), said input terminal being moreover electrically grounded (93) by way of a second resistor (457), said power supply being at a voltage level at least ten times lower than the voltage level of the DC voltage source, said microcontroller (453) being configured to determine the amplitude of an insulation defect as a function of the voltage applied to its input terminal.

7. Electrical power supply device according to any one of the preceding claims, in which each current limiter circuit comprises:

- a first transistor comprising an input electrode connected to a respective input terminal of the detection device, an output electrode and a control electrode;
- a first resistor (R1) connected between the input electrode and the control electrode;
- a second resistor (R2) connected between the output electrode and the intermediate point (49);
- an element for limiting the voltage level on the control electrode.

8. Electrical power supply device according to Claim 7, in which said first transistor is a MOSFET transistor (TC11).

9. Electrical power supply device according to Claim 7 or 8, in which the element for limiting the voltage level is a Zener diode connected between the control electrode of the first transistor and the intermediate point.

10. Electrical power supply device according to Claim 7 or 8, in which the element for limiting the voltage level is a bipolar transistor whose base is connected to the output electrode of the first transistor, whose emitter is connected to the intermediate point and whose collector is connected to the control electrode of the first transistor.

11. Electrical power supply device according to any one of the preceding claims, in which each of said current limiter circuits is rated so as to be traversed by a current of less than 3.5 mA when the first or the second current limiter circuit is closed and one of the terminals of the DC voltage source is short-circuited to the electrical ground.

12. Electrical power supply device according to any one of the preceding claims, in which each of said current limiter circuits is rated so as, when the control circuit applies a closing command to it, to remain closed when it is traversed by a current induced by a short-circuit between one of the terminals of the DC voltage source and the electrical ground.

13. Motorization system (1), comprising:

- an electrical power supply device according to any one of the preceding claims, in which the DC voltage source is a battery;
- an inverter (6) exhibiting a DC interface and an AC interface, the terminals of the battery being connected to the DC interface;
- an electric motor (7) connected to the AC interface of the inverter (6).

14. Motorization system according to Claim 13, in which the voltage across the terminals of the battery (2) is greater than 100 V.

15. Automotive vehicle (1) comprising a motorization system according to Claim 13 or 14.

Fig. 1

Fig. 2

Fig. 3

Fig. 4

Fig. 5

Fig. 6

Fig. 7

Fig. 8

Fig. 9

47

R3

41

R1

43

TC11

8

DZ1

DZ2

R2

93

49

Fig. 10

47

R3

41

R1

TC11

DZ1

R2

DZ2

8

43

93

49

Fig. 11

451

491

Vcc

Rs

Vde

93

Fig. 8

Fig. 12

45

Vcc

491

454 456

453

455 457

93

# Fig. 13

# Fig. 14

Fig. 15

Fig. 16

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2671190
- EP 1857825 A
- WO 2008088448 A
- US 2004212371 A